# FASCICULE DE BREVET EUROPEEN

(11) **EP 3 273 465 B1**
(45) Date de publication et mention de la délivrance du brevet: **12.06.2019**
(21) Numéro de dépôt: 17180671.4
(22) Date de dépôt: 11.07.2017
(51) Int. Cl.: H01L 21/18

(54) **PROCÉDÉ DE COLLAGE DIRECT MÉTAL-MÉTAL**
DIREKTES METALL-METALL-KLEBEVERFAHREN
DIRECT METAL-TO-METAL BONDING METHOD

(30) Priorité: 18.07.2016 FR 1656818
(43) Date de publication de la demande: 24.01.2018
(73) Titulaire: Commissariat à l'Energie Atomique et aux Energies Alternatives, 75015 Paris (FR)
(72) Inventeur: GONDCHARTON, Paul, 18150 GERMIGNY L'EXEMPT (FR); IMBERT, Bruno, 38054 GRENOBLE (FR); MORICEAU, Hubert, 38120 SAINT-EGREVE (FR)
(74) Mandataire: Cabinet Camus Lebkiri

(56) Documents cités:
- WO-A1-2016/059094
- GONDCHARTON P ET AL: "Effect of Copper-Copper Direct Bonding on Voiding in Metal Thin Films", 3 septembre 2015 (2015-09-03), JOURNAL OF ELECTRONIC MATERIALS, WARRENDALE, PA, US, PAGE(S) 4128 - 4133, XP035540230, ISSN: 0361-5235 [extrait le 2015-09-03] * page 4131, colonne de droite, alinéa 2 *

## Description

### DOMAINE TECHNIQUE

La présente invention concerne un procédé de collage direct métal-métal permettant d'assembler deux éléments, tels que des substrats en matériaux semi-conducteurs.

### ÉTAT DE LA TECHNIQUE

Le collage métal-métal trouve aujourd'hui de nombreuses applications dans le domaine de la microélectrique ou des nanotechnologies. À titre d'exemple, il est utilisé pour l'encapsulation de composants MEMS, pour la réalisation d'électrodes dans les cellules photovoltaïques et pour la réalisation de dissipateurs thermiques dans les composants de puissance.

Le collage métallique intervient également dans la fabrication de circuits intégrés en trois dimensions (3D-IC), car il permet d'empiler verticalement plusieurs substrats semi-conducteurs contenant des interconnexions métalliques tout en assurant la continuité électrique entre ces interconnexions. Les substrats assemblés présentent généralement une surface de collage hybride métal/diélectrique, c'est-à-dire une surface composée de plots et/ou de lignes métalliques entourés d'un matériau diélectrique. Le collage requiert alors un alignement des interconnexions métalliques appartenant aux deux substrats.

Plusieurs techniques connues de collage métallique permettent d'assembler deux substrats sans introduire de composé intermédiaire - tel qu'un adhésif, une cire ou un alliage à faible point de fusion - au niveau de l'interface de collage.

À titre d'exemple, le procédé de collage direct (non thermo-compressif) du cuivre comprend la mise en contact, en général à température ambiante, de deux couches de cuivre dont les surfaces sont lisses, hydrophiles et exemptes de contamination. Dans ce cas, les forces attractives entre les deux couches de cuivre (les forces de Van der Waals notamment) sont suffisamment élevées pour provoquer l'adhérence entre les deux substrats. L'assemblage des deux substrats est ensuite soumis à un recuit post-collage dit de stabilisation pour rendre le collage irréversible, mécaniquement robuste et électriquement conducteur.

D'après le document [« An Overview of Patterned Metal/Dielectric Surface Bonding: Mechanism, Alignment and Characterization », L. Di Cioccio et al., Journal of The Electrochemical Society, No. 158, pp.81-86, 2011], le collage direct peut être effectué à l'air et à température ambiante. On observe alors la présence de couches d'oxyde de cuivre à l'interface de collage. Ces couches d'oxyde de cuivre peuvent nuire à la qualité du collage, malgré le fait que l'oxyde de cuivre soit instable thermiquement et disparaisse pendant le recuit de stabilisation. Le collage direct peut aussi être accompli sous ultravide (UHV, pour « Ultra-High Vacuum » en anglais) pour éviter la formation des couches d'oxyde de cuivre en surface. Toutefois, les équipements permettant de créer et maintenir un ultravide sont particulièrement coûteux et lents, ce qui limite l'utilisation de cette technique.

Le procédé de collage direct à température et pression ambiantes est plus simple à mettre en oeuvre que d'autres techniques de collage métallique, en particulier le procédé de collage de cuivre assisté par thermocompression. En outre, le recuit de stabilisation s'effectue à basse température (environ 300 °C), ce qui évite d'altérer les propriétés des composants formés dans les substrats. Par contre, la qualité du collage direct est dépendante de l'état de surface des couches de cuivre avant collage. Des étapes de polissage mécano-chimique et de nettoyage sont donc généralement mises en oeuvre pour améliorer cet état de surface.

Le principal inconvénient du collage direct mis en évidence par la littérature est la présence après recuit de défauts, non seulement à l'interface de collage entre les deux couches de cuivre, mais également aux interfaces entre chaque couche de cuivre et le substrat sur lequel ladite couche a été déposée. Ces défauts se présentent généralement sous la forme de cavités (« voids » en anglais) et de dislocations. Dans le cas d'une intégration 3D-IC, ces défauts entraînent notamment des ouvertures de lignes (coupe-circuit des interconnexions) ou des phénomènes d'extrusion puis de court-circuit des interconnexions.

Des résidus d'oxyde de cuivre peuvent être responsables d'une partie des défauts à l'interface de collage. Cependant, comme discuté dans l'article [« Effect of Copper-Copper Direct Bonding on Voiding in Metal Thin Films », P. Gondcharton et al., Journal of Electronic Materials, Vol. 44, No. 11, pp.4128-4132, 2015], l'origine principale des autres défauts semble être les contraintes mécaniques qui s'exercent dans les deux couches de cuivre en contact pendant le recuit de stabilisation. Ces contraintes mécaniques sont dues à la différence des coefficients de dilatation entre le cuivre et le matériau des substrats qui supportent les couches de cuivre (en l'espèce, du silicium).

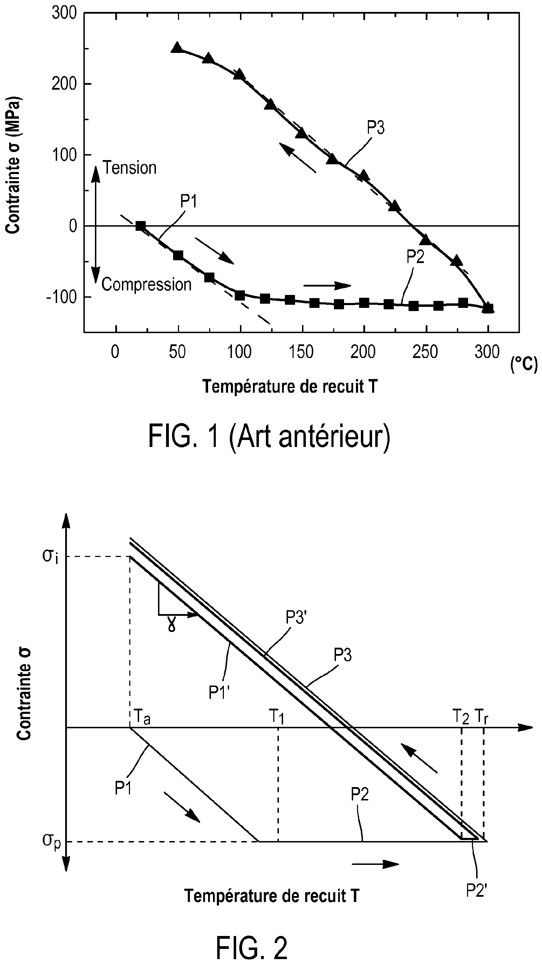

La figure 1 montre l'évolution de la contrainte bi-axiale σ dans le plan de deux couches de cuivre après leur collage, en fonction de la température T du recuit de stabilisation. Les valeurs positives de la contrainte σ correspondent à une contrainte en tension et les valeurs négatives de la contrainte σ correspondent à une contrainte en compression.

Le recuit de stabilisation correspond à un cycle thermique comprenant une montée en température (courbe inférieure) depuis la température ambiante (ici 25 °C) jusqu'à une température de 300 °C, puis un refroidissement (courbe supérieure). La montée en température se compose de deux phases P1 et P2 successives. Pendant la première phase P1 (25 °C-100 °C), qualifiée de phase thermoélastique, la contrainte σ des couches de cuivre diminue (en valeur relative) de façon sensiblement linéaire, jusqu'à atteindre la limite d'élasticité en compression du cuivre. Cette phase P1 est dirigée seulement par la différence de dilatation thermique entre les substrats (silicium) et les couches de cuivre. Pendant la deuxième phase P2 (100 °C-300 °C), la contrainte σ se maintient au niveau de la limite d'élasticité en compression. Cette phase de palier P2 correspond à un régime de plasticité des couches de cuivre, qui accommodent les déformations internes par des mécanismes de fluage et de germination de cavités. Durant cette phase P2, des défauts se créent aux interfaces avec les couches de cuivre. Enfin, la troisième phase P3 correspondant au refroidissement est une autre phase thermoélastique, où la contrainte σ augmente linéairement, passant d'une valeur négative (contrainte en compression) à une valeur positive (contrainte en tension).

### RÉSUMÉ DE L'INVENTION

La présente invention a pour but de limiter la formation de défauts, tels que des cavités ou des dislocations, lors du recuit de stabilisation d'un assemblage de deux substrats par collage direct métal-métal.

Selon l'invention, on tend vers cet objectif en prévoyant un procédé d'assemblage d'un premier substrat et d'un deuxième substrat par collage direct métal-métal, comprenant les étapes suivantes :
- fournir une première couche d'un métal en surface du premier substrat et une deuxième couche dudit métal en surface du deuxième substrat, les première et deuxième couches de métal présentant une contrainte en tension comprise entre 30 % et 100 % de la limite d'élasticité en tension dudit métal ;
- assembler les premier et deuxième substrats au niveau d'une interface de collage par la mise en contact direct des première et deuxième couches de métal contraintes en tension ; et
- soumettre l'assemblage des premier et deuxième substrats à un recuit de stabilisation à une température inférieure ou égale à un seuil de température au-delà duquel les première et deuxième couches de métal contraintes en tension se déforment plastiquement en compression.

L'utilisation de deux couches de métal présentant une contrainte en tension, préalablement à leur mise en contact direct, permet d'étendre le régime d'élasticité de ces couches (en configuration de collage) jusqu'à des températures suffisamment élevées pour réaliser le recuit de stabilisation. Par recuit de stabilisation, ou recuit post-collage, on entend le traitement thermique destiné à rendre le collage des deux substrats irréversible, mécaniquement robuste et électriquement conducteur. Ainsi, on minimise voire on évite lors du recuit de stabilisation le régime de plasticité des couches métalliques, principal responsable des défauts aux interfaces entre les couches métalliques et les substrats d'une part, et à l'interface de collage (i.e. entre les deux couches métalliques) d'autre part.

Selon un développement de l'invention, le procédé d'assemblage comprend en outre une étape de calcul dudit seuil de température à partir de la contrainte en tension des première et deuxième couches de métal et du coefficient thermoélastique dudit métal.

Dans un mode de mise en oeuvre préférentiel du procédé d'assemblage, la contrainte en tension des première et deuxième couches de métal est obtenue après dépôt lors d'une étape d'adaptation de contrainte.

L'étape d'adaptation de contrainte peut comporter un traitement thermique suivi d'un refroidissement, le traitement thermique étant effectué à une température inférieure ou égale à une température limite au-delà de laquelle les première et deuxième couches de métal se déforment plastiquement en tension en refroidissant, la température du traitement thermique fixant alors le seuil de température du recuit de stabilisation.

De préférence, le refroidissement s'effectue jusqu'à la température ambiante.

La température du recuit de stabilisation est avantageusement égale à la température du traitement thermique.

Alternativement, l'étape d'adaptation de contrainte est une étape de traitement plasma ou bombardement ionique.

Dans une variante de mise en oeuvre, la contrainte en tension des première et deuxième couches de métal est obtenue lors du dépôt de la première couche de métal sur une face du premier substrat et de la deuxième couche de métal sur une face du deuxième substrat.

Le procédé d'assemblage selon l'invention peut également présenter une ou plusieurs des caractéristiques ci-dessous, considérées individuellement ou selon toutes les combinaisons techniquement possibles :
- l'assemblage des premier et deuxième substrats est effectué sous air ambiant ;
- l'assemblage des premier et deuxième substrats est effectué à température ambiante ;

- les premier et deuxième substrats sont constitués de matériaux identiques ;
- les premier et deuxième substrats sont en silicium et les première et deuxième couches de métal sont en cuivre ;
- les première et deuxième couches de métal ont une épaisseur comprise entre 10 nm et 5 µm ;
- le procédé comprend en outre, avant l'étape d'assemblage des premier et deuxième substrats, au moins une étape de préparation de la surface des première et deuxième couches de métal.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1, précédemment décrite, représente la contrainte bi-axiale qui s'exerce dans le plan de deux couches métalliques collées directement entre elles lors d'un recuit de stabilisation du collage ;
- la figure 2 représente, de façon schématique, la même contrainte bi-axiale, dans le cas où une précontrainte en tension est appliquée aux couches métalliques et dans le cas de la figure 1, où aucune précontrainte n'est appliquée ;
- la figure 3 représente des étapes d'un procédé d'assemblage de deux substrats par collage direct métal-métal selon l'invention ;
- la figure 4A représente l'étape consistant à appliquer une contrainte en tension aux deux couches métalliques avant leur mise en contact, d'après un mode de mise en oeuvre préférentiel du procédé d'assemblage selon l'invention ;
- la figure 4B représente l'étape du recuit de stabilisation après la mise en contact des deux couches métalliques, d'après le mode de mise en oeuvre préférentiel du procédé selon l'invention ;
- les figures 5A et 5B montrent en vue de coupe deux assemblages de substrats, obtenus respectivement avec le procédé selon l'invention et un procédé de l'art antérieur.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

Par définition, la limite d'élasticité est la contrainte à partir de laquelle un matériau arrête de se déformer d'une manière élastique (ou réversible). À partir de cette contrainte, une déformation permanente apparaît. On observe alors comme illustré sur la figure 1 une phase P2 dans laquelle la contrainte évolue de façon moindre, voire devient constante. On schématisera par la suite cette phase par un palier que l'on nommera « palier de plasticité ».

Dans la description qui suit, « σ_{ρ} » désigne la limite d'élasticité en compression et « σₑ » désigne la limite d'élasticité en tension.

La figure 2 est un graphique semblable à celui de la figure 1 et représente l'évolution de la contrainte bi-axiale σ dans le plan de deux couches métalliques en fonction de la température T d'un recuit de stabilisation. Les deux couches, formées du même métal, ont été collées l'une contre l'autre avant d'être soumises au recuit de stabilisation.

La figure 2 montre deux cycles thermiques correspondant à deux cas de figure distincts. Le premier cycle thermique, comprenant successivement la phase thermoélastique P1, le palier de plasticité P2 et la phase thermoélastique P3, correspond à celui représenté sur la figure 1, c'est-à-dire au cas de deux couches métalliques présentant avant collage une contrainte nulle (σ = 0 à T = 25 °C, i.e. avant recuit). Le deuxième cycle thermique, comprenant successivement la phase thermoélastique P1', le palier de plasticité P2' et la phase thermoélastique P3', correspond au cas deux couches métalliques qui ont été soumises à une contrainte en tension σᵢ avant d'être collées (σ = σᵢ >> 0 à T = 25 °C, i.e. avant recuit). Pour chaque cycle thermique, le palier de plasticité P2/P2' débute lorsque la contrainte σ atteint la limite d'élasticité en compression σₚ du métal et prend fin à la température de consigne Tᵣ du recuit. Après un certain temps à la température de consigne Tᵣ, la température T du recuit diminue. Ce refroidissement correspond à la phase thermoélastique P3/P3'.

On constate que le palier de plasticité P2' des couches ayant été précontraintes en tension s'étend sur une plage de températures beaucoup moins importante que le palier de plasticité P2 des couches n'ayant subi aucune précontrainte. En effet, la phase thermoélastique P1' des couches précontraintes s'étend jusqu'à une température T2 bien supérieure à la température T1, où prend fin la phase thermoélastique P1 des couches non-contraintes. L'augmentation de la température T lors du recuit de stabilisation étant sensiblement constante avec le temps, cela signifie que les couches métalliques précontraintes en tension auront passé moins de temps en régime de plasticité (P2) que les couches n'ayant subi aucune contrainte. Par conséquent, un nombre moins important de défauts sera généré aux interfaces des couches métalliques précontraintes lors du recuit de stabilisation.

Le procédé d'assemblage par collage direct métal-métal selon l'invention met en application ce principe pour limiter au maximum les défauts générés lors du recuit de stabilisation. La contrainte initiale et les conditions du recuit sont choisies de sorte que les couches métalliques, en configuration de collage, échappent au palier de plasticité.

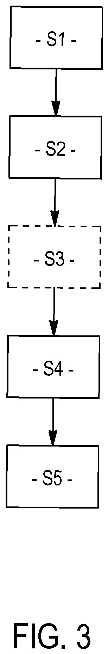

La figure 3 représente des étapes S1 à S5 de ce procédé d'assemblage.

La première étape S1 consiste à prévoir deux substrats présentant chacun une couche métalliques en surface. Les substrats peuvent être des plaquettes semi-conductrices, par exemple à base de silicium, dont une face est recouverte au moins partiellement par une couche métallique. Ces substrats peuvent notamment présenter une surface de collage hybride, composée d'interconnexions métalliques (lignes, plots) entourées d'un matériau diélectrique, par exemple un oxyde ou un nitrure (cas des circuits intégrés 3D notamment). Alternativement, leur surface de collage peut être entièrement métallique.

Les couches métalliques présentes en surface des deux substrats sont avantageusement constituées d'un même métal, de préférence choisi parmi le cuivre (Cu), l'or (Au), le nickel (Ni), le molybdène (Mo), le palladium (Pd), l'aluminium (Al), l'argent (Ag), le tungstène (W) et le platine (Pt). Elles peuvent être également constituées d'un alliage de ces métaux. Les substrats peuvent aussi être constitués entièrement de ce métal ou cet alliage.

La surface des deux substrats peut également présenter plusieurs couches métalliques formées de métaux différents (choisis parmi ceux susmentionnés).

Dans un mode de mise en oeuvre de l'étape S1, une première couche de métal est déposée sur une face d'un premier substrat et une deuxième couche du même métal est déposée sur une face d'un deuxième substrat. Le matériau du premier substrat et le matériau du deuxième substrat peuvent être choisis parmi le silicium, le saphir (alumine), le verre, le quartz, le carbure de silicium (SiC), le niobate de lithium (LiNbO₃), le tantalate de lithium (LiTaO₅) et les métaux. Ils sont de préférence identiques. Les première et deuxième couches de métal sont par exemple obtenues par une technique de dépôt physique en phase vapeur (PVD), telle que l'évaporation ou la pulvérisation cathodique, par dépôt chimique en phase vapeur (CVD) ou par électrodéposition (ECD).

Les deux couches de métal sont avantageusement des couches minces dont les épaisseurs sont comprises entre 10 nm et 5 µm. Elles sont ainsi plus stables thermiquement et leur uniformité pourra être préservée lors du recuit de stabilisation ultérieur.

Ces couches de métal peuvent être contraintes directement lors du dépôt afin d'obtenir une contrainte initiale en tension σᵢ comprise entre 30 % (avantageusement 50% voire 70%) et 100 % de la limite d'élasticité en tension σₑ du métal. La contrainte initiale en tension σᵢ des couches métalliques est, de préférence, mesurée à la température ambiante Tₐ (cf. Fig.2), par exemple de 25 °C. Elle est inférieure ou égale à la limite d'élasticité en tension σₑ car, au-delà de cette limite, les couches métalliques se déforment plastiquement et peuvent à terme perdre leur intégrité.

Alternativement, le procédé d'assemblage de la figure 3 comprend après le dépôt S1 une étape S2 consistant à contraindre les deux couches métalliques, par exemple par traitement thermique, bombardement ionique ou traitement plasma.

Comme décrit précédemment en relation avec la figure 2, la précontrainte en tension obtenue après le dépôt S1 ou après l'étape S2 permet d'étendre le régime d'élasticité des couches métalliques en configuration de collage jusqu'à des températures suffisamment élevées pour effectuer un recuit de stabilisation du collage sans déformation plastique des couches.

Le procédé comprend également avantageusement une ou plusieurs étapes de préparation de la surface des couches métalliques. Cette étape de préparation S3, optionnelle, peut notamment avoir pour but de diminuer la rugosité de surfaces des couches métalliques et/ou de rendre hydrophiles les surfaces à assembler, afin d'obtenir une adhésion forte entre les deux substrats lors du collage direct métal-métal. L'étape S3 comprend par exemple un polissage mécano-chimique (CMP) de la face libre des couches métalliques. Ce polissage est avantageusement suivi d'un nettoyage, par exemple par voie humide, afin d'éliminer les particules résiduelles générées par le polissage. Elle peut également comprendre un traitement plasma.

Cette étape de préparation S3 est en général effectuée après l'étape S2. Par exemple, une étape de polissage mécano-chimique est effectuée après une mise en contrainte par traitement thermique. Naturellement, d'autres variantes de mise en oeuvre sont possibles. Si la mise en contrainte est effectuée par un traitement plasma qui préserve l'hydrophilie de surface, l'étape de CMP peut être effectuée avant ce traitement plasma. On peut également prévoir une étape de CMP (pour ajuster la rugosité de surface) puis une étape de mise sous contrainte et enfin une étape de préparation chimique (pour ajuster l'hydrophilie de surface).

Lors de l'étape S4, les premier et deuxième substrats sont assemblés par la mise en contact direct des première et deuxième couches de métal. Cette étape de collage direct peut être effectuée sous une atmosphère contrôlée, par exemple une atmosphère de gaz inerte (N₂) ou une atmosphère anhydre, ou sous vide. Dans la mesure où le procédé d'assemblage limite la formation de défauts à l'interface de collage en évitant la déformation plastique des couches métalliques, le collage direct peut aussi être effectué sous air ambiant. Le collage est ainsi plus simple et moins coûteux à mettre en oeuvre.

Le collage direct de l'étape S4 peut être accompli manuellement, notamment lorsqu'il est effectué à température ambiante et sous air ambiant, ou de façon automatisée dans un équipement dédié. Par ailleurs, le collage peut requérir dans certains cas, comme celui des surfaces de collage hybrides (circuits intégrés en trois dimensions notamment), un alignement préalable des motifs métalliques appartenant au premier substrat avec ceux du deuxième substrat. L'alignement et le collage sont de préférence effectués dans le même équipement.

Enfin, à l'étape S5, l'assemblage des deux substrats est soumis au recuit de stabilisation. Plus la contrainte initiale en tension σᵢ est choisie proche de la limite d'élasticité en tension σₑ, plus la température maximale autorisée pour le recuit de stabilisation peut être élevée. Par « température maximale autorisée », on entend le seuil de température au-delà duquel les couches métalliques précontraintes se déforment plastiquement en compression, soit la température T2 de la figure 2.

La contrainte initiale en tension σᵢ est de préférence comprise entre 70 % et 100 %, et plus préférentiellement encore entre 80 % et 100 %, de la limite d'élasticité en tension σₑ. Ainsi, le recuit de stabilisation peut être accompli à une température plus élevée, ce qui élargit le choix du métal et/ou assure un meilleur assemblage.

La température maximale autorisée du recuit de stabilisation peut être calculée à partir de la contrainte en tension σᵢ initialement choisie et du coefficient thermoélastique γ du métal dans la configuration d'assemblage utilisée (le coefficient thermoélastique γ, qui représente la pente de la droite σ(T) lors de la première phase thermoélastique P1', dépend également de la nature des substrats sur lesquels sont déposées les couches métalliques). Cette température maximale est par exemple comprise entre 250 °C et 400 °C dans le cas d'une couche de cuivre déposée sur un substrat de silicium. À l'inverse, si le recuit de stabilisation doit être effectué à une température donnée, le coefficient thermoélastique γ du métal permet de calculer la contrainte initiale en tension σᵢ qu'il faut appliquer aux couches métalliques pour que le régime d'élasticité prenne fin à cette température.

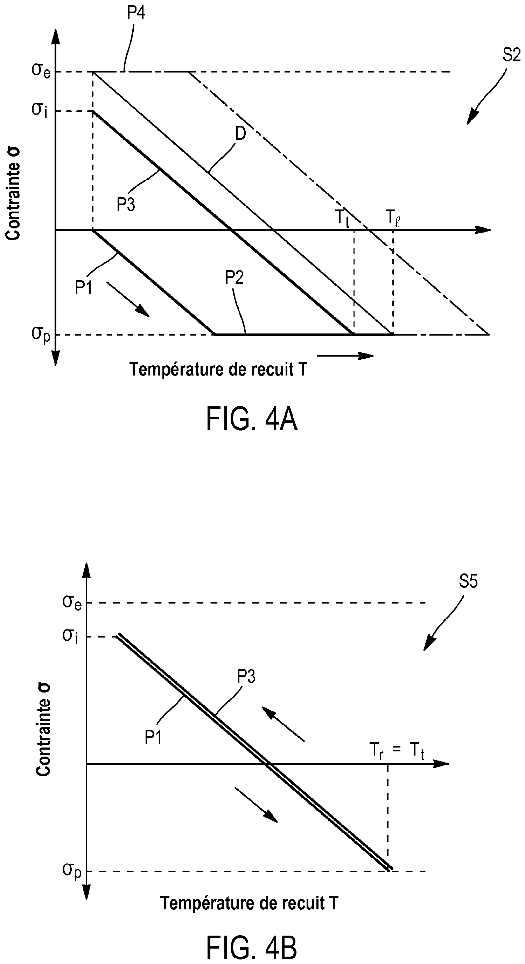

Les figures 4A et 4B représentent respectivement l'étape de mise en contrainte S2 et l'étape de recuit de stabilisation S5 selon un mode de mise en oeuvre préférentiel du procédé d'assemblage.

Dans ce mode de mise en oeuvre préférentiel, la contrainte initiale en tension σᵢ est obtenue par un recuit de précontrainte, distinct du recuit de stabilisation mis en oeuvre à l'étape S5 du procédé d'assemblage. La figure 1 a précédemment montré que le recuit de stabilisation de l'art antérieur permettait de passer d'une contrainte nulle à une contrainte en tension. Le recuit de précontrainte mis en oeuvre à l'étape S2 peut donc être effectué dans les mêmes conditions que le recuit de stabilisation de l'art antérieur, à la différence que les couches métalliques ne seront pas encore collées.

Ainsi, le recuit de précontrainte des couches métalliques comprend un traitement thermique, durant lequel la température des couches métalliques augmente de la température ambiante Tₐ jusqu'à une température de consigne Tₜ, puis un refroidissement, de préférence jusqu'à la température ambiante Tₐ (cf. Fig.4A). Le traitement thermique comprend, à l'instar de la montée en température de la figure 1, une phase thermoélastique P1 (jusqu'à atteindre la limite d'élasticité en compression σₚ du métal) puis un palier de plasticité P2 jusqu'à la température de consigne Tₜ.

Lors du recuit de précontrainte, les deux couches métalliques ne sont pas en configuration de collage, mais en configuration de surface libre. Ainsi, lorsqu'elles subissent le palier de plasticité P2, les couches métalliques peuvent se déformer librement. Le recuit de précontrainte ne génère donc pas de défauts en surface ou à l'intérieur des couches métalliques, contrairement au recuit de stabilisation de l'art antérieur.

Le refroidissement des couches métalliques lors du recuit de précontrainte s'effectue entièrement en régime élastique (phase thermoélastique P3), afin que les couches métalliques ne perdent pas leur intégrité. En effet, à la différence du régime de plasticité en compression (palier P2), le régime de plasticité en tension P4 (Fig.4A) dégrade les couches métalliques, même lorsqu'elles sont en configuration de surface libre. La température de consigne Tₜ du traitement thermique est donc inférieure ou égale à une température limite Tₗ pour laquelle la contrainte des couches métalliques à la température ambiante Tₐ est égale à la limite d'élasticité en tension σₑ du métal (σ = σₑ, à T = Tₐ = 25 °C ; cf. droite D sur la figure 4A). Au-delà de cette température limite Tₗ (en trait mixte sur la figure 4A), les couches métalliques se déformeront plastiquement en tension en refroidissant jusqu'à la température ambiante (au cours du refroidissement avant collage, au cours du refroidissement post-collage ou au cours du refroidissement post-recuit de stabilisation).

La température limite Tₗ du recuit de précontrainte peut être calculée à partir de la limite d'élasticité en tension σₑ du métal et du coefficient thermoélastique γ du métal (i.e. la pente de la droite D sur la figure 4A).

La phase thermoélastique de refroidissement P3 lors du recuit de précontrainte peut également s'arrêter à une température supérieure à la température ambiante Tₐ, par exemple à 50 °C ou 100 °C. Le collage direct de l'étape S4 est alors effectué à cette température. Il pourra être utile dans ce cas d'appliquer une pression extérieure (thermocompression) pour obtenir le collage. En effet, les surfaces après le traitement thermique de précontrainte peuvent ne plus être suffisamment hydrophiles pour assurer le collage direct à pression ambiante.

Le recuit de stabilisation S5 (après le collage direct S4) est, dans ce mode de mise en oeuvre préférentiel, effectué à une température Tᵣ inférieure ou égale à la température de consigne Tₜ du recuit de précontrainte. En d'autres termes, la température de consigne Tₜ du recuit de précontrainte fixe le seuil de température, ou température maximale autorisée, du recuit de stabilisation.

Ainsi, les couches métalliques n'entreront pas dans le régime de plasticité P2 en compression et le cycle thermique se compose uniquement des phases thermoélastiques P1 et P3, qui se superposent (cf. Fig.4B).

Comme cela est illustré sur la figure 4B, la température Tᵣ du recuit de stabilisation est avantageusement égale à la température de consigne Tₜ du recuit de précontrainte. On choisit ainsi la température la plus élevée possible tout en évitant la déformation plastique des couches.

Dans une variante de mise en oeuvre du procédé d'assemblage, la contrainte initiale en tension σᵢ des première et deuxième couches de métal est obtenue lors de leur dépôt respectif sur les premier et deuxième substrats, en contrôlant les paramètres du dépôt tels que la température ou la pression de gaz dans l'enceinte de dépôt. L'étape S2 d'adaptation de la contrainte n'est alors plus nécessaire. À titre d'exemple, le document [« Residual stress, microstructure, and structure of tungsten thin films deposited by magnetron sputtering », Y. G. Shen et al., Journal of Applied Physics, vol.87, p.177, 2000] indique que des couches en tungstène déposées par PVD peuvent être contraintes en tension en contrôlant la pression d'argon (et plus généralement, tout gaz inerte) dans l'enceinte de dépôt.

Alternativement, la contrainte initiale en tension σᵢ des couches métalliques peut être obtenue lors d'un traitement par plasma ou bombardement ionique, postérieurement à leur dépôt sur les substrats.

Les valeurs de limites d'élasticité en tension σₑ et en compression σₚ des différents métaux ou alliages de métaux susmentionnés sont bien référencés dans la littérature et sont sensiblement identiques entre la configuration de couches minces (10 nm-5 µm) et en volume (couches d'épaisseur supérieure à 5µm). Les coefficients thermoélastiques γ dépendent bien sûr du métal choisi, mais également de la nature des substrats sur lesquels les couches de métal sont déposées. Si le coefficient thermoélastique γ n'est pas donné dans la littérature, il peut être aisément calculé à partir des coefficients de dilatation des différents matériaux et des dimensions géométriques de la configuration étudiée. Il peut également être obtenu facilement à partir de mesures à deux températures (par exemple à température ambiante et à 100 °C).

Le tableau ci-dessous donne à titre d'exemple les valeurs de ces grandeurs physiques pour plusieurs métaux couramment utilisés en microélectronique : le cuivre, le tungstène et l'aluminium. Dans le cas du cuivre, plusieurs type de substrats ont été envisagés : en silicium, en carbure de silicium (SiC) et en phosphure d'indium (InP).

| | | | | | |
|---|---|---|---|---|---|
| Substrat | Silicium | Silicium | Silicium | SiC | InP |
| Couche mince | W | Al | Cu | Cu | Cu |
| Mode de dépôt | CVD | PVD | PVD/ECD | PVD/ECD | PVD/ECD |
| σₑ (Mpa) | 1200 | 120 | 300 | 300 | 300 |
| σₚ (Mpa) | -120 | -50 | -150 | -150 | -150 |
| γ(Mpa/K) | -0,6 | -2,1 | -1,2 | -1,8 | -1,6 |
| Tₗ (°C) | 2200 | 101 | 388 | 270 | 301 |

Le tableau donne également, pour chaque combinaison de substrat, métal et mode de dépôt, la température limite Tₗ du traitement de précontrainte (et donc du recuit de stabilisation) calculée à partir de la contrainte d'élasticité en tension σₑ et du coefficient thermoélastique γ.

Les deux substrats à assembler sont de préférence constitués des mêmes matériaux (silicium, SiC, InP, saphir...) pour faciliter la détermination du coefficient thermoélastique γ des couches de métal. Pour la même raison, les couches de métal sont avantageusement de la même épaisseur (comprise entre 10 nm et 5 µm).

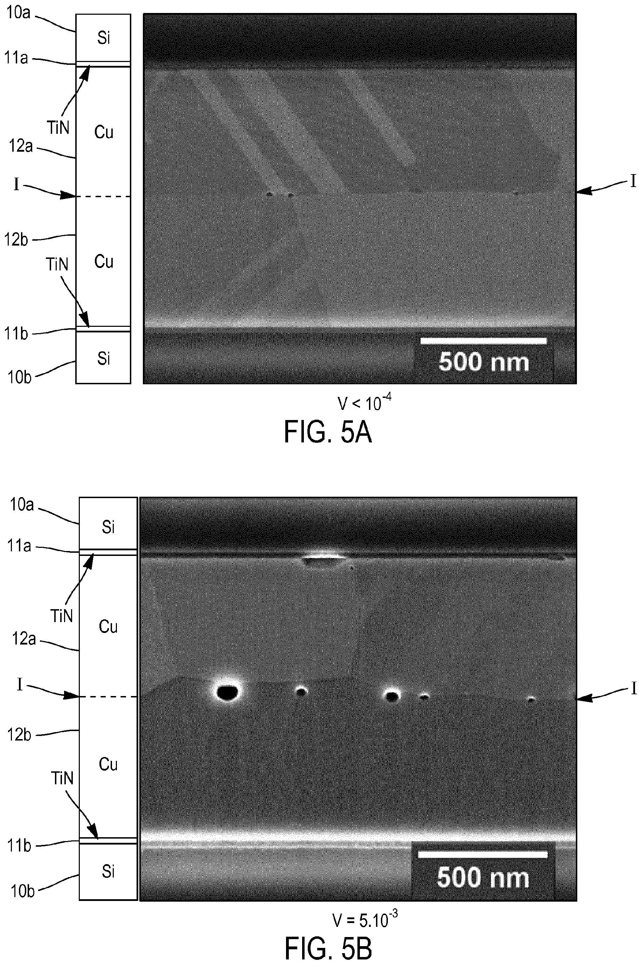

Un exemple de mise en oeuvre du procédé d'assemblage va maintenant être décrit en référence à la figure 5A.

À l'étape S1, des premier et deuxième substrats 10a-10b en silicium, de 200 mm de diamètre, sont recouverts respectivement d'une première couche barrière 11a et d'une deuxième couche barrière 11b en nitrure de titane (TiN), puis d'une première couche 12a et d'une deuxième couche 12b en cuivre. Les couches en nitrure de titane 11a-11b, de 20 nm d'épaisseur, et les couches de cuivre 12a-12b, de 1 µm d'épaisseur, sont obtenues par dépôt physique en phase vapeur (PVD). Elles recouvrent toute une face des substrats 10a-10b. Les dépôts du TiN et du cuivre sur les substrats 10a-10b sont réalisés successivement dans le même équipement, sans remise à l'air libre des substrats.

Le dépôt physique en phase vapeur est effectué à température ambiante (25 °C) sous une atmosphère d'argon (pression = 8,5 mTorr), à une tension de polarisation d'environ 5 kV.

À l'issue du dépôt, les couches de cuivres 12a et 12b sont quasiment relaxées (σᵢ < 20 MPa en tension).

En S2, chaque substrat 10a-10b (recouvert des couches de TiN et de cuivre) est soumis à un traitement thermique sous vide secondaire pendant 10 h à 400 °C. Après refroidissement, la contrainte en tension des couches de cuivre 12a-12b est de 250 MPa environ (± 50 MPa).

Puis, la face libre des couches de cuivre 12a-12b est polie et nettoyée (étape S3) afin de diminuer la rugosité de surface. Cette rugosité passe d'une valeur de 5 nm en moyenne quadratique, ou « RMS » pour « Roughness Mean Square » en anglais, à une valeur inférieure à 0,5 nm RMS.

Les substrats sont ensuite assemblés par collage direct (étape S4) en mettant en contact les surfaces polies des couches de cuivre 12a-12b. Un front de collage est initié manuellement par pression localisée (par exemple au stylet), puis se propage à toute la surface de collage des couches de cuivre 12a-12b.

L'assemblage des substrats 10a-10, des couches de TiN 11a-11b et des couches de cuivre 12a-12b est symétrique par rapport à l'interface de collage I situé entre les deux couches de cuivre 12a-12b, car les substrats 10a et 10b sont de même épaisseur (ainsi que les couches de TiN 11a-11b et les couches de cuivre 12a-12b).

Enfin, l'assemblage est recuit pendant 2 h à 300 °C après une montée en température de 1 °C/min. Ce recuit de stabilisation permet de rendre le collage définitif.

En plus de la représentation schématique (à gauche), la figure 5A montre (à droite) une coupe prise au microscope électronique à balayage de l'assemblage des deux substrats 10a-10b. La fraction volumique V des défauts (ici des cavités) à l'interface de collage et aux interfaces entre les couches de cuivre 12a-12b et les couches de TiN 11a-11b est inférieure à 10⁻⁴. La fraction volumique V de défauts est définie comme le volume des défauts sur le volume total du cuivre (couche 12a + couche 12b).

À titre de comparaison, la figure 4B montre une coupe MEB d'un assemblage de même structure (substrats 10a-10b/couches de TiN 11a-11b/couches de cuivre 12a-12b), obtenu par le procédé de collage direct de l'art antérieur. Les défauts aux interfaces sont non seulement plus nombreux, mais également plus volumineux. La fraction volumique V des défauts dans l'assemblage de la figure 5B est d'environ 5.10⁻³, soit plus d'un ordre de grandeur supérieure à la fraction volumique V de l'assemblage de la figure 5A. Le procédé d'assemblage selon l'invention permet donc de diminuer considérablement le volume des défauts dans les couches de cuivre.

## Revendications

1. Procédé d'assemblage d'un premier substrat (10a) et d'un deuxième substrat (10b) par collage direct métal-métal, comprenant les étapes suivantes :
- fournir une première couche (12a) d'un métal en surface du premier substrat et une deuxième couche (12b) dudit métal en surface du deuxième substrat ;
- assembler (S4) les premier et deuxième substrats au niveau d'une interface de collage (I) par la mise en contact direct des première et deuxième couches de métal (12a, 12b) ;
- soumettre (S5) l'assemblage des premier et deuxième substrats à un recuit de stabilisation ;
**caractérisé en ce que** l'étape de fourniture est mise en oeuvre de façon à obtenir des première et deuxième couches de métal présentant une contrainte en tension (σᵢ) comprise entre 30 % et 100 % de la limite d'élasticité en tension (σₑ) dudit métal, et **en ce que** le recuit de stabilisation est effectué à une température (Tᵣ) inférieure ou égale à un seuil de température (T2) au-delà duquel les première et deuxième couches de métal contraintes en tension se déforment plastiquement en compression.

2. Procédé selon la revendication 1, comprenant une étape de calcul dudit seuil de température (T2) à partir de la contrainte en tension (σᵢ) des première et deuxième couches de métal (12a, 12b) et du coefficient thermoélastique (γ) dudit métal.

3. Procédé selon l'une des revendications 1 et 2, dans lequel l'étape de fourniture comprend une étape de dépôt (S1) de la première couche de métal (12a) sur une face du premier substrat (10a) et de la deuxième couche de métal (12b) sur une face du deuxième substrat (10b).

4. Procédé selon la revendication 3, dans lequel la contrainte en tension (σᵢ) des première et deuxième couches de métal (12a, 12b) est obtenue lors de l'étape de dépôt (S1).

5. Procédé selon l'une quelconque des revendications 1 à 3, dans lequel la contrainte en tension (σᵢ) des première et deuxième couches de métal (12a, 12b) est obtenue après dépôt lors d'une étape (S2) d'adaptation de contrainte.

6. Procédé selon la revendication 5, dans lequel l'étape (S2) d'adaptation de contrainte est une étape de traitement plasma ou bombardement ionique.

7. Procédé selon la revendication 5, dans lequel l'étape (S2) d'adaptation de contrainte comprend un traitement thermique (P1-P2) suivi d'un refroidissement (P3), le traitement thermique étant effectué à une température (Tₜ) inférieure ou égale à une température limite (Tₗ) au-delà de laquelle les première et deuxième couches de métal se déforment plastiquement en tension en refroidissant, et dans lequel la température du traitement thermique (Tₜ) fixe le seuil de température (T2) du recuit de stabilisation.

8. Procédé selon la revendication 7, dans lequel le refroidissement (P3) s'effectue jusqu'à la température ambiante (Tₐ).

9. Procédé selon l'une des revendications 7 et 8, dans lequel la température (Tᵣ) du recuit de stabilisation est égale à la température (Tₜ) du traitement thermique.

10. Procédé selon l'une quelconque des revendications 1 à 9, dans lequel l'assemblage des premier et deuxième substrats (10a-10b) est effectué sous air ambiant.

11. Procédé selon l'une quelconque des revendications 1 à 10, dans lequel les premier et deuxième substrats (10a-10b) sont constitués de matériaux identiques.

12. Procédé selon l'une quelconque des revendications 1 à 11, dans lequel les premier et deuxième substrats (10a-10b) sont en silicium et les première et deuxième couches de métal (12a-12b) sont en cuivre.

13. Procédé selon l'une quelconque des revendications 1 à 12, dans lequel les première et deuxième couches de métal (12a-12b) ont une épaisseur comprise entre 10 nm et 5 µm.

14. Procédé selon l'une quelconque des revendications 1 à 13, comprenant en outre, avant l'étape (S4) d'assemblage des premier et deuxième substrats (10a-10b), au moins une étape (S3) de préparation de la surface des première et deuxième couches de métal (12a-12b).

## Patentansprüche

1. Montageverfahren eines ersten Substrats (10a) und eines zweiten Substrats (10b) per direktem Verkleben Metall / Metall, umfassend die folgenden Schritte:
- Liefern einer ersten Schicht (12a) eines Metalls an der Oberfläche des ersten Substrats und einer zweiten Schicht (12b) des genannten Metalls an der Oberfläche des zweiten Substrats;
- Montieren (S4) des ersten und zweiten Substrats an einer Verklebungs-Schnittstelle (I) per direktem Kontaktieren der ersten und zweiten Metallschichten (12a, 12b);
- Unterwerfen (S5) der Montage des ersten und zweiten Substrats einem Stabilisierungs-Nachglühen;
**dadurch gekennzeichnet, dass** der Lieferschritt derart umgesetzt ist, dass erste und zweite Metallschichten erhalten werden, die eine Spannungsbeanspruchung (σᵢ) aufweisen, die zwischen 30 % und 100 % der Streckgrenze unter Spannung (σₑ) des genannten Metalls inbegriffen ist, und dass das Stabilisierungs-Nachglühen bei einer Temperatur (Tᵣ) unter oder gleich einem Temperatur-Schwellenwert (T2) durchgeführt ist, über den hinaus die erste und zweite unter Spannung beanspruchte Metallschicht sich plastisch in Komprimierung verformen.

2. Verfahren gemäß Anspruch 1, umfassend einen Berechnungsschritt des genannten Temperatur-Schwellenwertes (T2) ausgehend von der Spannungsbeanspruchung (σᵢ) der ersten und zweiten Metallschicht (12a, 12b) und des thermoplastischen Koeffizienten (γ) des genannten Metalls.

3. Verfahren gemäß einem der Ansprüche 1 und 2, bei dem der Lieferschritt einen Aufbringungsschritt (S1) der ersten Metallschicht (12a) auf einer Seite des ersten Substrats (10a) und der zweiten Metallschicht (12b) auf einer Seite des zweiten Substrats (10b) umfasst.

4. Verfahren gemäß Anspruch 3, bei dem die Spannungsbeanspruchung (σᵢ) der ersten und zweiten Metallschicht (12a, 12b) beim Aufbringungsschritt (S1) erhalten ist.

5. Verfahren nach irgendeinem der Ansprüche 1 bis 3, bei dem die Spannungsbeanspruchung (σᵢ) der ersten und zweiten Metallschicht (12a, 12b) nach dem Aufbringen bei einem Spannungsanpassungsschritt (S2) erhalten ist.

6. Verfahren gemäß Anspruch 5, bei dem der Spannungsanpassungsschritt (S2) ein Plasmabehandlungs- oder Ionenbombardierungsschritt ist.

7. Verfahren gemäß Anspruch 5, bei dem der Spannungsanpassungsschritt (S2) eine Wärmebehandlung (P1 - P2), gefolgt von einem Abkühlen (P3) umfasst, wobei die Wärmebehandlung bei einer Temperatur (Tₜ) unter oder gleich einer Grenztemperatur (Tₗ) durchgeführt ist, über die hinaus die erste und zweite Metallschicht sich unter Spannung beim Abkühlen plastisch verformen und bei der die Temperatur der Wärmebehandlung (Tₜ) den Temperaturschwellenwert (T2) des Stabilisierungs-Nachglühens festlegt.

8. Verfahren gemäß Anspruch 7, bei dem das Abkühlen (P3) bis zur Umgebungstemperatur (Tₐ) erfolgt.

9. Verfahren gemäß einem der Ansprüche 7 und 8, bei dem die Temperatur (Tᵣ) des Stabilisierungs-Nachglühens gleich der Temperatur (Tₜ) der Wärmebehandlung ist.

10. Verfahren gemäß irgendeinem der Ansprüche 1 bis 9, bei dem die Montage des ersten und zweiten Substrats (10a - 10b) unter Umgebungsluft erfolgt ist.

11. Verfahren gemäß irgendeinem der Ansprüche 1 bis 10, bei dem das erste und zweite Substrat (10a - 10b) aus identischen Materialien gebildet sind.

12. Verfahren gemäß irgendeinem der Ansprüche 1 bis 11, bei dem das erste und zweite Substrat (10a - 10b) aus Silizium sind und die erste und zweite Metallschicht (12a - 12b) aus Kupfer sind.

13. Verfahren gemäß irgendeinem der Ansprüche 1 bis 12, bei dem die erste und zweite Metallschicht (12a - 12b) eine zwischen 10 nm und 5 µm inbegriffene Dicke haben.

14. Verfahren gemäß irgendeinem der Ansprüche 1 bis 13, umfassend darüber hinaus vor dem Montageschritt (S4) des ersten und zweiten Substrats (10a - 10b) wenigstens einen Vorbereitungsschritt (S3) der Oberfläche der ersten und zweiten Metallschicht (12a - 12b).

## Claims

1. Method for assembling a first substrate (10a) and a second substrate (10b) by a metal-metal direct bonding, comprising the following steps of:
- providing a first layer (12a) of a metal at the surface of the first substrate and a second layer (12b) of said metal at the surface of the second substrate;
- assembling (S4) the first and second substrates at a bonding interface (I) by directly contacting the first and second metal layers (12a, 12b);
- subjecting (S5) the assembly of the first and second substrates to a stabilization annealing;
**characterized in that** the providing step is performed so as to obtain first and second metal layers having a tensile stress (σᵢ) comprised between 30 % and 100 % of the tensile yield strength (σₑ) of said metal, and **in that** the stabilization annealing is performed at a temperature (Tᵣ) lower than or equal to a temperature threshold (T2) beyond which the first and second tensile stressed metal layers are plastically compressively deformed.

2. Method according to claim 1, comprising a step of calculating said temperature threshold (T2) from the tensile stress (σᵢ) of the first and second metal layers (12a, 12b) and the thermo-elastic coefficient (γ) of said metal.

3. Method according to one of claims 1 and 2, wherein the providing step comprises a step (S1) of depositing the first metal layer (12a) onto a face of the first substrate (10a) and the second metal layer (12b) onto a face of the second substrate (10b).

4. Method according to claim 3, wherein the tensile stress (σᵢ) of the first and second metal layers (12a, 12b) is obtained during the depositing step (S1).

5. Method according to any of claims 1 to 3, wherein the tensile stress (σᵢ) of the first and second metal layers (12a, 12b) is obtained after deposition during a stress adaptation step (S2).

6. Method according to claim 5, wherein the stress adaptation step (S2) is a step of plasma treatment or ion bombardment.

7. Method according to claim 5, wherein the stress adaptation step (S2) comprises a heat treatment (P1-P2) followed by a cooling (P3), the heat treatment being performed at a temperature (Tₜ) lower than or equal to a temperature limit (Tₗ) beyond which the first and second metal layers are plastically tensile deformed by cooling, and wherein the temperature of the heat treatment (Tₜ) sets the temperature threshold (T2) of the stabilization annealing.

8. The method according to claim 7, wherein the cooling (P3) is performed up to the ambient temperature (Tₐ).

9. The method according to one of claims 7 and 8, wherein the temperature (Tᵣ) of the stabilization annealing is equal to the temperature (Tₜ) of the heat treatment.

10. The method according to any of claims 1 to 9, wherein the assembling of the first and second substrates (10a-10b) is performed under ambient air.

11. The method according to any of claims 1 to 10, wherein the first and second substrates (10a-10b) are comprised of identical materials.

12. The method according to any of claims 1 to 11, wherein the first and second substrates (10a-10b) are made of silicon and the first and second metal layers (12a, 12b) are made of copper.

13. The method according to any of claims 1 to 12, wherein the first and second metal layers (12a-12b) have a thickness comprised between 10 nm and 5 µm.

14. The method according to any of claims 1 to 13, further comprising, before the step (S4) of assembling the first and second substrates (10a-10b), at least one step (S3) of preparing the surface of the first and second metal layers (12a, 12b).
